Europäisches Patentamt

European Patent Office

Office européen des brevets

(11) Veröffentlichungsnummer: **0 467 012 A1**

## (12) EUROPÄISCHE PATENTANMELDUNG

(21) Anmeldenummer: **91102613.6**

(22) Anmeldetag: **22.02.91**

(51) Int. Cl.5: **H01J 37/34**

(30) Priorität: **14.07.90 DE 4022461**

(43) Veröffentlichungstag der Anmeldung:
**22.01.92 Patentblatt 92/04**

(84) Benannte Vertragsstaaten:
**CH DE FR GB LI NL**

(71) Anmelder: **LEYBOLD AKTIENGESELLSCHAFT**
**Wilhelm-Rohn-Strasse 25**
**W-6450 Hanau am Main 1(DE)**

(72) Erfinder: **Cord, Bernhard, Dr.**
**Freigerichter Strasse 33**
**W-8755 Alzenau(DE)**
Erfinder: **Maass, Wolfram, Dr.**
**Fröbelstrasse 2**
**W-6455 Erlensee(DE)**

(74) Vertreter: **Sartorius, Peter, Dipl.-Ing.**
**Patentanwalt**
**Elisabethenstrasse 24**
**W-6803 Edingen-Neckarhausen 2(DE)**

(54) Zerstäubungskathode.

(57) Die Erfindung bezieht sich auf eine Zerstäubungskathode (1) nach dem Magnetron-Prinzip mit einem aus mindestens einem Teil bestehenden Target (11) sowie mit einem hinter dem Target (11) angeordneten Magnetsystem. Die durch Sputtern gebildeten Vertiefungen (18) innerhalb des Targets (11) werden mittels eines Sensors (28) erfaßt, der kontinuierlich oder in definierbaren Zeitintervallen die Dicke des Targets (11) mißt. Damit läßt sich eine optimale Nutzung des Targets (11) erzielen, und es wird verhindert, daß hinter dem Target befindliche Materialien abgetragen werden.

Fig. 1

Die Erfindung bezieht sich auf eine Zerstäubungskathode nach dem Magnetron-Prinzip mit einem aus mindestens einem Teil bestehenden Target und einem hinter dem Target angeordneten Magnetsystem mit mindestens zwei ineinanderliegenden Magneteinheiten abwechselnd unterschiedlicher Polung, die mindestens einen gleichfalls in sich geschlossenen, magnetischen Tunnel aus bogenförmig gekrümmten Feldlinien bilden, wobei die dem Target abgekehrten Pole der Magneteinheiten über ein Magnetjoch miteinander verbunden sind. Die Anordnung muß nicht notwendigerweise rotationssymmetrisch sein. Beim Einsatz der Kathode befindet sich das Target im Vakuum einer Vakuumkammer, die mit einem Arbeitsgas gefüllt ist. Der Magnetron-Effekt besteht darin, daß in dem erwähnten magnetischen Tunnel unterhalb des Targets ein in sich geschlossener Plasmaring brennt. Die aus dem Plasma heraus be-schleunigten Gasionen schlagen Atome aus dem Target heraus (Zerstäubungseffekt, = engl.:sputtern) und erodieren das Target oberhalb des Plasmaschlauches.

Demgemäß besteht die Erfindungsaufgabe darin, daß die Tiefe der durch dieses Sputtern gebildeten Erosionsgräben (siehe Abb.) innerhalb des Targets mittels mindestens eines Sensors erfaßt wird. Hierzu ist es vorteilhaft, daß ein oder mehrere Sensoren an der Rückseite des Targets vorgesehen sind. In weiterer Ausgestaltung der Erfindung ist es vorteilhaft, daß der Sensor mit einer Auswerteinheit zusammenwirkt, die die Vertiefungen im Target erfaßt und nach Erreichen einer definierbaren kritischen Tiefe ein optisches bzw. akustisches Signal auslöst oder den Arbeitsprozeß automatisch unterbricht.

Aufgrund der erfindungsgemäßen Ausgestaltung ist der Sensor als Ultraschallsensor ausgebildet und mißt kontinuierlich oder in definierbaren Zeitintervallen die Dicke des Targets an einer Position stärkster Targeterosion. Dabei ist der Ultraschallsensor über einen in den Targethaltetopf (Kathodenrumpf) integrierten Ultraschalleiter direkt an das Target angekoppelt. In weiterer Ausgestaltung der Erfindung ist es vorteilhaft, daß die Auswerteinheit über einen elektrischen Schaltkreis ansteuerbar ist, der mit mindestens einem Ultraschallsensor zusammenwirkt und so die Dicke des Targets erfaßt. Auf diese Weise kann während der einzelnen Arbeitspausen oder während eines laufenden Arbeitsprozesses die Abnutzung des Targets einwandfrei erfaßt und damit sichergestellt werden, daß eine Beschichtung eines Substrats nur so lange erfolgt, wie das Target eine ausreichende Stärke aufweist. Damit wird verhindert, daß das Sputtern über die Targetdicke hinaus fortgesetzt wird und somit Fremdmaterialien (z.B. aus der Stirnplatte der Kathode oder Lötmaterial im Falle eines gelöteten Targets) in die Substrate gelangen.

Mit dieser evtl. automatischen Überwachungsmethode kann also eine einwandfreie Beschichtung bei optimaler Targetnutzung erfolgen, auch während eines laufenden Arbeitsverfahrens. Durch die optische oder akustische Warneinrichtung wird die Bedienungsperson rechtzeitig darauf hingewiesen, wenn die kritische Dicke des Targets unterschritten wird.

Weitere Merkmale der Erfindung sind in der Beschreibung der Figuren dargestellt, wobei bemerkt wird, daß alle Einzelmerkmale und alle Kombinationen von Einzelmerkmalen erfindungswesentlich sind.

In den Figuren ist die Erfindung an einer Ausführungsform beispielsweise dargestellt, ohne auf diese Ausführungsform beschränkt zu sein. Es zeigt:

Figur 1    eine Vorrichtung zur Ultraschalldickenmessung mit einem Ultraschallmeßsensor, der an der Rückseite des Targethaltetopfs angebracht ist,

Figur 2    einen Ultraschallsensor zur Ermittlung der Targeterosion in Abhängigkeit der Sputterzeit.

Figur 3    eine Ansicht von unten eines kreisförmigen Targets.

In der Zeichnung ist mit 1 eine Zerstäubungskathode bezeichnet, deren tragender Teil aus einem hohlförmigen, topfartigen Grundkörper 2 (Targethaltetopf) besteht, der wegen der thermischen Belastung aus einem gut wärmeleitenden Werkstoff, beispielsweise aus Kupfer, besteht und mittels eines umlaufenden Flanschs 3 unter Zwischenschaltung eines Isolierstoffkörpers 4 in eine Wand 5 eines in der Zeichnung nur teilweise dargestellten Gehäuses bzw. einer Vakuumkammer einsetzbar ist.

Die Zerstäubungskathode 1 steht mit einer elektrischen Stromversorgung in Verbindung. An die Vakuumkammer ist eine in der Zeichnung nicht dargestellte Vakuumpumpe angeschlossen.

Der Grundköper 2 weist eine größtenteils ebene Stirnplatte 6 auf. An der Innenseite der Stirnplatte 6 sind drei konzentrisch angeordnete Kühlwasserkanäle 7,8,9 vorgesehen, die über einen Wasseranschlußstutzen 35 mit einer in der Zeichnung nicht dargestellten Pumpe verbunden sind.

An der Unterseite der Stirnplatte 6 ist ein Target 11 angelötet (engl.: bonden), das auch über Schraubenbolzen mit der Stirnplatte 6 verbunden sein kann.

Oberhalb der Kühlwasserkanäle 7,8,9 des Grundkörpers 2 befinden sich Magneteinheiten 14,15, die mit Bezug auf die Mittelachse A konzentrisch angeordnet sind. Die Magneteinheiten 14,15 bestehen aus einem permanent magnetischen Material und sind in axialer Richtung magnetisiert. Die mittlere Magneteinheit 14 ist als zylinderförmige Scheibe ausgebildet. Die äußeren, ebenfalls konzentrisch zur Mittelachse angeordneten Magneteinheiten 15 sind in vorteilhafter Weise aus zahlreichen plattenförmigen Permanentmagneten zusammengesetzt.

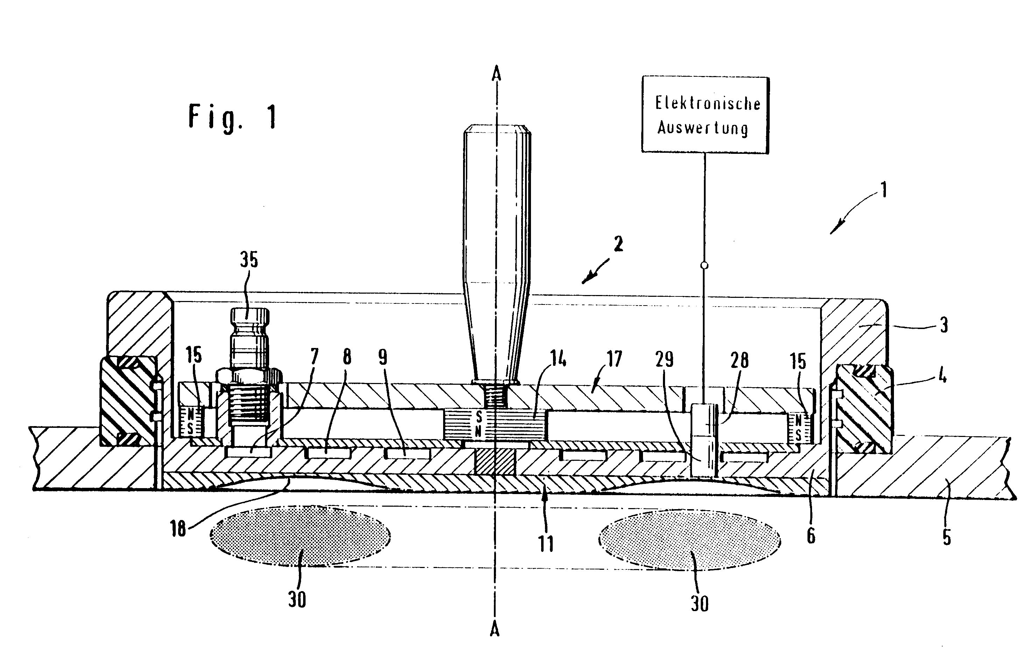

Die dem Target 11 abgewandten Pole der Magneteinheiten 14,15, sind über ein Magnetjoch 17 aus weichmagnetischem Material (Figur 1) verbunden.

Die Magneteinheiten 14,15 sind dabei abwechselnd gepolt, und zwar bilden die dem Target 11 zugekehrten Polflächen bei der Magneteinheit 14 einen Nordpol und bei der Magneteinheit 15 einen Südpol. Dies führt zur Ausbildung eines magnetischen Tunnels, der auf der Targetseite um die Achse A-A umlaufend geschlossen ist.

Oberhalb des Targets 11 ist ein Ultraschallsensor 28 so im Targethaltetopf angebracht, daß der ausgesendete und dann an der Targetoberfläche reflektierte Ultraschall über einen Ultraschalleiter 29 ohne innere Grenzflächen gut geleitet werden kann. Es ist natürlich auch möglich, diesen Sensor 28 oder mehrere Sensoren an unterschiedlichen Positionen zu plazieren. Dabei kann es notwendig sein, den Ultraschallsensor elektrisch isoliert gegen den Grundkörper 2 und gegen die Jochplatte aufzubauen.

Gegenüber dem Target 11 befindet sich ein in der Zeichnung nicht dargestellter Substrathalter mit einem zu beschichtenden Substrat. Wird nach Einlaß eines Gases, beispielsweise Argon, in die Vakuumkammer eine Spannung an die Kathode 1 angelegt, so ionisieren die in der Vakuumkammer vorhandenen Elektronen das Argon, und unter geeigneten Druckbedingungen bildet sich eine sog. selbständige Gasentladung in Form eines Plasmas. Durch den bereits erwähnten magnetischen Tunnel hat dieses Plasma die Form eines ringförmigen Plasmaschlauches und ist in Figur 1 mit 30 gekennzeichnet. Die Argonionen im Plasma werden durch das elektrische Feld zwischen Plasma und Target geradlinig in Richtung auf das Target 11 beschleunigt und schlagen aufgrund ihrer hohen Energie Atome oder Atomcluster aus dem Targetmaterial heraus, die sich dann auf dem Substrat niederschlagen. Auf diese Weise wird nach einer bestimmten Zeit die gewünschte Schicht gebildet und das Target abgetragen. Es bilden sich also an der Stelle, auf der die meisten Ionen auftreffen, ringförmige Vertiefungen 18.

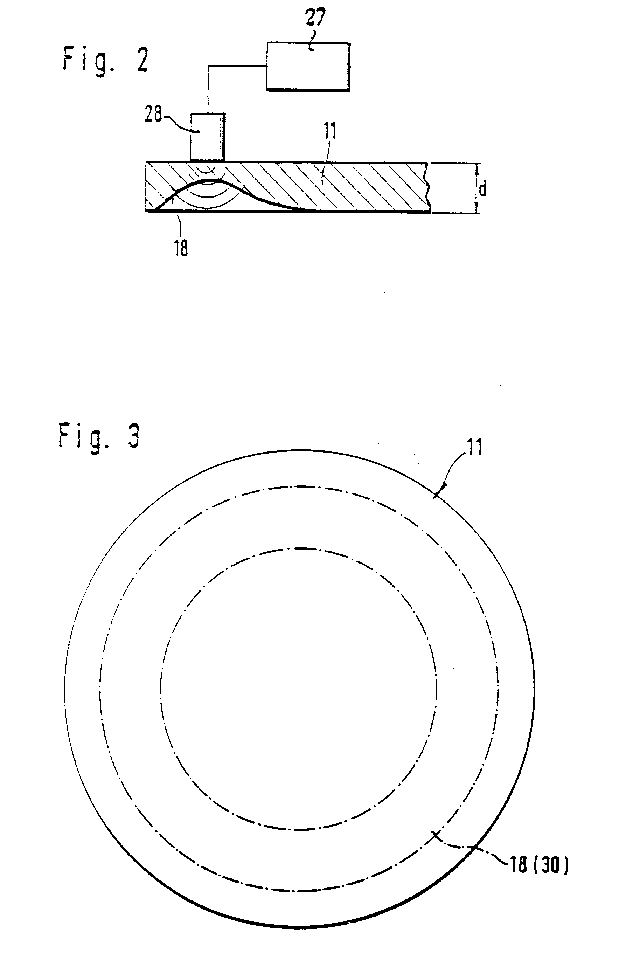

Der in Figur 3 angegebene Ring 18 deutet diese Vertiefungen an, der in etwa den gleichen Durchmesser wie der unterhalb des Targets 11 gebildete Ring des Plasmas 30 hat. Daraus ergibt sich, daß das Target 11 an dieser Stelle immer dünner wird.

Bei kontinuierlich arbeitenden Anlagen ohne Kontrolle der Targetdicke besteht das Problem, daß bei durcherodiertem Target die Lötschicht und der Targethaltetopf selbst abgetragen und das entsprechende Material zusätzlich zum Targetmaterial auf den Substraten abgeschieden wird. Dadurch geht i.A die Qualität der erzeugten Schichten verloren, und die Substrate sind nicht mehr zu verwenden.

Da die Targets mitunter sehr teuer sind, möchte man einerseits diese so weit wie möglich nutzen, andererseits aber den oben beschriebenen Effekt des Durcherodierens verhindern. Der für die vorliegende Erfindung wesentliche Ultraschallsensor 28 mißt fortlaufend bzw. in ganz bestimmten Zeitintervallen die Dicke des Targets 11 im Bereich dieses Erosionsgrabens 18. Aus den einzelnen Meßdaten lassen sich auf einfache Weise genaue Aussagen über den Grad der Targeterosion machen, und somit kann eine optimale Nutzung des Targets erzielt werden.

Mit Hilfe der oben beschriebenen Sensorik in Verbindung mit einer elektronischen Auswerteeinheit 27 läßt sich die kritische Targetstärke während des Sputterprozesses oder zwischen Einzelbeschichtungen auf etwa 0.1 mm genau messen. Damit ist eine optimale Endpunktbestimmung im oben genannten Sinne möglich.

Es ist ferner vorteilhaft, wenn die gemessene Targetdicke von der Auswertungseinheit dem Bedienungspersonal kontinuierlich oder in gewissen Zeitabständen, z.B. über ein Display, übermittelt wird, wobei bei Erreichen einer kritischen Dicke ein optisches oder akustisches Signal übermittelt oder der Prozess automatisch beendet wird.

Bezugszeichenliste

| | |
|---|---|
| 1 | Zerstäubungskathode = Kathode |
| 2 | Grundkörper (Targethaltetopf) |
| 3 | Flansch |
| 4 | Isolierstoffkörper |
| 5 | Wand der Vakuumkammer |
| 6 | Stirnplatte |
| 7 | Kühlwasserkanal |
| 8 | Kühlwasserkanal |
| 9 | Kühlwasserkanal |
| 11 | Target |
| 14 | Magneteinheit |
| 15 | Magneteinheit |
| 17 | Magnetjoch |
| 18 | ringförmige Vertiefung |
| 27 | elektronische Auswerteeinheit |
| 28 | Sensor = Ultraschallsensor |
| 29 | Ultraschalleiter |
| 30 | Plasma |
| 35 | Wasseranschlußstutzen |

**Patentansprüche**

**1.** Zerstäubungskathode nach dem Magnetron-Prinzip mit einem aus mindestens einem Teil bestehenden Target (11) und einem hinter dem Target (11) angeordneten Magnetsystem, mit mehreren, ineinanderliegenden Magneteinheiten (14,15) abwechselnd unterschiedlicher Polung, die mindestens einen gleichfalls in sich geschlossenen, magnetischen Tunnel aus bogenförmig gekrümmten Feldlinien bilden, wobei die dem Target (11) abgekehrten Pole der Magnet-einheiten (14,15) über ein Magnetjoch (17) miteinander verbunden sind, **dadurch gekennzeichnet**, daß die durch Sputtern gebildete Vertiefung (18) innerhalb des Targets (11) mittels eines Sensors (28) vermessen wird.

2.  Zerstäubungskathode nach Anspruch 1, **dadurch gekennzeichnet**, daß ein oder mehrere Sensoren (28) an der Rückseite des Targets (11) vorgesehen sind.

3.  Zerstäubungskathode nach Anspruch 1 oder 2, **dadurch gekennzeichnet**, daß der Sensor (28) mit einer Auswerteeinheit 27 zusammenwirkt, die den Grad der Vertiefung (18) im Target (11) erfaßt und nach Erreichen einer definierbaren, kritischen Tiefe ein optisches bzw. akustisches Signal auslöst oder den Arbeitsprozeß automatisch unterbricht.

4.  Zerstäubungskathode nach einem oder mehreren der vorhergehenden Ansprüche, **dadurch gekennzeichnet, daß** der Sensor (28) als Ultraschallsensor ausgebildet ist, der kontinuierlich oder in definierbaren Zeitintervallen die Dicke des Targets mißt.

5.  Zerstäubungskathode nach einem oder mehreren der vorhergehenden Ansprüche, **dadurch gekennzeichnet, daß** die Auswerteeinheit mit mindestens einem Ultraschallsensor (28) zusammenwirkt, der etwa im Bereich stärkster Targeterosion auf der Rückseite des Targets (11) angeordnet ist und dort die Dicke des Targets erfaßt.

Fig. 1

Elektronische
Auswertung

EP 0 467 012 A1

Fig. 2

Fig. 3

**Europäisches Patentamt**

# EUROPÄISCHER
# RECHERCHENBERICHT

Nummer der Anmeldung

# EP 91 10 2613

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| Y | GB-A-2 199 340 (BALZERS AG) <br> * ZUSAMMENFASSUNG * * * Seite 11, Zeile 8 - Seite 12, Zeile 27; Abbildung 1 * * <br> – – – | 1-5 | H 01 J 37/34 |
| Y | US-A-4 437 332 (PITTARO) <br> * Spalte 1, Zeile 6 - Zeile 19 * * * Spalte 3, Zeile 1 - Zeile 14 * * * Spalte 4, Zeile 1 - Zeile 17; Abbildung 1 * * <br> – – – | 1-5 | |
| A | EP-A-0 259 934 (PHILIPS AND DU PONT OPTICAL) <br> * Spalte 1, Zeile 1 - Zeile 11 * * * Spalte 6, Zeile 53 - Spalte 8, Zeile 27; Ansprüche 1-5; Abbildungen 1-3 * * <br> – – – | 1-3 | |
| A | EP-A-0 316 523 (LEYBOLD AG) <br> * Spalte 1, Zeile 1 - Zeile 21 * * * Spalte 4, Zeile 32 - Spalte 6, Zeile 6; Abbildung 1 * * <br> – – – – – | 1 | |

| RECHERCHIERTE SACHGEBIETE (Int. Cl.5) |
|---|
| H 01 J <br> G 01 B |

Der vorliegende Recherchenbericht wurde für alle Patentansprüche erstellt

| Recherchenort | Abschlußdatum der Recherche | Prüfer |
|---|---|---|
| Den Haag | 25 November 91 | GREISER N. |

KATEGORIE DER GENANNTEN DOKUMENTE
X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus anderen Gründen angeführtes Dokument

-----------------------------------------------------------------------

& : Mitglied der gleichen Patentfamilie, übereinstimmendes Dokument